# EUROPÄISCHE PATENTSCHRIFT

(11) **EP 3 755 937 B1**
(45) Veröffentlichungstag und Bekanntmachung des Hinweises auf die Patenterteilung: **03.08.2022**
(21) Anmeldenummer: 19708029.4
(22) Anmeldetag: 18.02.2019
(51) Int. Cl.: F16P 3/14, G01V 8/12

(54) **OPTOELEKTRONISCHE SICHERHEITSVORRICHTUNG UND VERFAHREN ZUM ÜBERWACHEN EINER MASCHINENBEWEGUNG**
OPTOELECTRONIC SAFETY DEVICE AND METHOD FOR MONITORING A MOVEMENT OF A MACHINE
DISPOSITIF DE SÉCURITÉ OPTOÉLECTRONIQUE ET PROCÉDÉ DE SURVEILLANCE DU MOUVEMENT D'UNE MACHINE

(30) Priorität: 20.02.2018 DE 102018103729
(43) Veröffentlichungstag der Anmeldung: 30.12.2020
(73) Patentinhaber: Fraba B.V., 6416 SG Heerlen (NL)
(72) Erfinder: LILIENTHAL, Christian, 51067 Köln (DE)
(74) Vertreter: terpatent Patentanwälte ter Smitten Eberlein-Van Hoof Rütten Daubert
(86) Internationale Anmeldenummer: PCT/EP2019/053957
(87) Internationale Veröffentlichungsnummer: WO 2019/162229

(56) Entgegenhaltungen:
- EP-A1- 2 990 836
- EP-A2- 2 527 878
- DE-A1-102009 045 322
- DE-U1-202008 018 463
- US-B1- 9 761 113

## Beschreibung

Die Erfindung betrifft eine optoelektronische Sicherheitsvorrichtung zum Überwachen einer Maschinenbewegung, insbesondere zur Überwachung der Bewegung eines Tors oder einer Tür, mit einer Erfassungsvorrichtung, mit mindestens einer Sendereinheit zum Senden eines optischen Signals, und mindestens einer Empfängereinheit zum Empfangen des optischen Signals, und einer Steuerungsvorrichtung mit einer Auswerteeinheit zum Auswerten des an der Empfängereinheit empfangenen Signals, wobei die Steuerungsvorrichtung bei einer Intensität des empfangenen Signals innerhalb eines erlaubten Intensitätsbereichs die Maschinenbewegung freigibt und bei einer Intensität des empfangenen Signals außerhalb eines erlaubten Intensitätsbereichs einen Auslöseimpuls zum Stoppen der Maschinenbewegung ausgibt. Ferner betrifft die Erfindung ein Verfahren zum Überwachen einer Maschinenbewegung.

Derartige Sicherheitsvorrichtungen werden häufig dort verwendet, wo ein Bewegungsbereich eines Konstruktionselements einer Maschine oder einer Vorrichtung zur Vermeidung von Kollisionen überwacht werden muss. Typische Anwendungsgebiete sind Durchgänge oder Durchfahrten mit automatisch schließenden bzw. motorisch angetriebenen Industrietoren.

Aus dem Stand der Technik sind zahlreiche solcher Sicherheitsvorrichtungen bekannt. So beschreibt beispielsweise die DE 20 2008 009 320 U1 eine optoelektronische Sicherheitsvorrichtung, die eine Erfassungsvorrichtung beinhaltet, um beispielsweise Gefahren durch bewegte Maschinenteile im Torbereich zu vermeiden. Des Weiteren sind aus der DE 37 28 354 und der EP 2 990 836 A1 optoelektronische Sicherheitsvorrichtungen an Toranlagen, bestehend aus einer Erfassungsvorrichtung mit einer Sendereinheit und einer Empfängereinheit, einer Steuereinheit sowie Lichtquellen bekannt. Ferner ist aus der US 9,761,113 B1 eine gattungsgemäße optoelektronische Sicherheitsvorrichtungen zum Überwachen einer Produktionsanlage bekannt.

Optoelektronische Sicherheitsvorrichtungen weisen zumeist eine Sendereinheit und eine Empfängereinheit auf, zwischen welchen ein optisches Signal, beispielsweise ein Lichtstrahl, übermittelt wird. Dadurch kann ein Gefahrenbereich, in dem eine Maschinenbewegung erfolgt, stetig überwacht werden. Wird das optische Signal durch ein Hindernis im Gefahrenbereich unterbrochen, wird von der Steuerungsvorrichtung ein Auslöseimpuls zum Stoppen der Maschinenbewegung ausgegeben.

Ein bekanntes Problem bei derartigen optoelektronischen Erfassungsvorrichtungen ist, dass die an der Empfängereinheit empfangene Intensität des optischen Signals zum einen von dem Abstand zwischen der Empfängereinheit und der Sendereinheit abhängig ist, und zum anderen von der Umgebungstemperatur beeinflusst wird. Ferner kann es auch verschleißbedingt zu einer Änderung der empfangenen Signalintensität kommen. Um einen Ordnungsgemäßen Betrieb der Sicherheitsvorrichtung zu ermöglichen und häufige Fehlauslösungen der Sicherheitsvorrichtung zu vermeiden, muss daher die Erfassungsvorrichtung, insbesondere die Sendereinheit, speziell für die vorliegenden Gegebenheiten der zu überwachende Maschine ausgelegt und/oder adaptiert werden. Bei starken Temperaturunterschieden oder bei ausgeprägtem Verschleiß der Maschine können auf Grund der resultierenden Änderungen der empfangenen Signalintensität dennoch unerwünschte Fehlauslösungen der Erfassungsvorrichtung auftreten.

Es stellt sich daher die Aufgabe, eine optoelektronische Sicherheitsvorrichtung zum Überwachen einer Maschinenbewegung zu schaffen, mit der die zuvor genannten Nachteile im Stand der Technik überwunden werden können, und die insbesondere eine zuverlässige Überwachung des Gefahrenbereichs ermöglicht und dabei einfach zu installieren ist.

Diese Aufgabe wird durch eine optoelektronische Sicherheitsvorrichtung zum Überwachen einer Maschinenbewegung mit den Merkmalen des Hauptanspruchs 1 gelöst.

Erfindungsgemäß weist das optische Signal eine Sequenz von mehreren Signalpulsen auf, wobei die Signalpulse voneinander verschiedene Pulsintensitäten aufweisen, weist die Steuerungsvorrichtung einen Pulsauswahlindex auf, über den ein in der Auswerteeinheit auszuwertender Signalpuls des empfangenen optischen Signals vorbestimmt ist, und weist die Steuerungsvorrichtung eine Pulsauswahleinheit auf, die geeignet ist, bei einer Pulsintensität des über den Pulsauswahlindex vorbestimmten Signalpulses außerhalb eines optimalen Intensitätsbereichs den Pulsauswahlindex zu ändern.

Die Pulsintensitäten der Signalsequenz sind dabei derart ausgebildet, dass sie einen breiten Intensitätsbereich abdecken. Dies ermöglicht der erfindungsgemäßen Sicherheitsvorrichtung eine ordnungsgemäße Überwachung der Maschinenbewegung auch bei Änderungen der empfangenen Signalintensität, beispielweise auf Grund starker Temperaturunterschiede. Die Pulsauswahleinheit adaptiert hierbei den Pulsauswahlindex derart, dass der Auswerteeinheit ein Signalpuls mit einer auswertbaren Intensität bereitgestellt wird. Ferner ist die erfindungsgemäße Sicherheitsvorrichtung geeignet, sich durch Auswahl eines Signalpulses mit einer geeigneten Pulsintensität automatisch an unterschiedliche Abstände zwischen der Sendereinheit und der Empfängereinheit anzupassen, sodass keine spezielle Auslegung der Sendereinheit oder aufwendige Adaption der Erfassungsvorrichtung an die zu überwachende Maschine erforderlich ist.

Vorzugsweise weisen die Signalpulse innerhalb der Sequenz eine von dem ersten Signalpuls zu dem letzten Signalpuls kontinuierlich ansteigende oder kontinuierlich abfallende Pulsintensität auf. Dies ermöglicht der Pulsauswahleinheit eine einfache Auswahl eines Signalpulses mit einer geeigneten Pulsintensität. Wenn der über den Pulsauswahlindex vorbestimmte Signalpuls eine zu geringe Pulsintensität aufweist, dann erhöht/verringert die Pulsauswahleinheit den Pulsauswahlindex, um den Signalpuls mit der nächsthöheren Pulsintensität auszuwählen. Wenn der über den Pulsauswahlindex vorbestimmte Signalpuls eine zu hohe Pulsintensität aufweist, dann verringert/erhöht die Pulsauswahleinheit den Pulsauswahlindex, um den Signalpuls mit der nächstniedrigeren Pulsintensität auszuwählen.

In einer bevorzugten Ausführung der Erfindung ist die Steuerungsvorrichtung, die Auswerteeinheit oder die Pulsauswahleinheit in die Erfassungsvorrichtung integriert. Insbesondere kann die Auswerteeinheit oder die Pulsauswahleinheit in die Empfängereinheit integriert sein. Dies ermöglicht einen besonders kompakten Aufbau der Sicherheitsvorrichtung.

Vorteilhafterweise weist die Erfassungsvorrichtung mindestens zwei Sendereinheiten und mindestens zwei Empfängereinheiten auf. Die Mehrzahl von Sendereinheiten bzw. Empfängereinheiten sind dabei vorzugsweise entlang einer Tiefenausdehnung der Maschine angeordnet und senden/empfangen parallel verlaufende optische Signale. Dies ermöglicht eine zuverlässige Überwachung von Maschinen, die eine relative große Tiefenausdehnung aufweisen, und daher mit einer einzelnen Sendereinheit/Empfängereinheit nur umständlich oder gar nicht zu überwachen sind.

Besonders vorteilhaft sind die Sendereinheiten ausgebildet, jeweils ein optisches Signal mit einer Sequenz von Signalpulsen zu senden, wobei sich die Signalpulssequenzen der einzelnen Signale zeitlich nicht überlappen. Hierdurch werden Interferenzen zwischen den einzelnen Signalen der mehreren Sendereinheiten minimiert, und somit die Zuverlässigkeit der Sicherheitsvorrichtung maximiert.

Vorteilhafterweise weist die Steuerungsvorrichtung mindestens zwei Pulsauswahlindizes auf, wobei die Anzahl der Pulsauswahlindizes vorzugsweise der Anzahl der Sendereinheiten/Empfängereinheiten entspricht und somit der Anzahl übertragener optischer Signale entspricht. Dies ermöglicht die separate Auswahl eines Signalpulses mit einer geeigneten Pulsintensität für jedes übertragene optische Signal, und somit eine besonders zuverlässige Überwachung der gesamten Tiefe der Maschine.

In einer vorteilhaften Ausführung der Erfindung weist die Steuerungsvorrichtung oder die Auswerteeinheit ein Zeitmodul auf, das geeignet ist, die Dauer der unerlaubten Signalintensität zu erfassen und bei Überschreiten einer Mindestdauer den Auslöseimpuls zum Stoppen der Maschinenbewegung auszugeben. Dadurch kann eine Fehlauslösung bei einer nicht durch ein Hindernis verursachten Signalabschwächungen bzw. einem Signalausbleiben verhindert werden.

In einer bevorzugten Ausführung der Erfindung ist die Empfängereinheit oder die Auswerteeinheit geeignet, ein eingehendes Analogsignal in ein ausgehendes Digitalsignal umzuwandeln. Dadurch kann anhand des ausgangsseitigen Digitalsignals in relativ einfacher Weise festgestellt werden, ob ein Auslöseimpuls, das heißt eine Signalintensität außerhalb eines erlaubten Intensitätsbereichs vorliegt oder nicht. Beispielsweise kann bei Vorliegen einer unerlaubten Intensität im Digitalsignal eine logische "Eins" ausgegeben werden und bei einer erlaubten Intensität eine logische "Null" ausgeben werden. Hierfür können die Empfängereinheit oder Auswerteeinheit beispielweise einen Schmitt-Trigger aufweisen. Dies ermöglicht eine einfache und kostengünstige Sicherheitsvorrichtung.

Vorteilhafterweise ist die Auswerteeinheit oder die Pulsauswahleinheit in einem Mikroprozessor integriert. Der Mikroprozessor kann die gesamte Steuerungsvorrichtung der Sicherheitsvorrichtung und kann ferner auch eine Motorelektronik des Maschinenantriebs umfassen. Dadurch kann eine zentrale Steuerung der Maschinenbewegung erfolgen. Ferner kann die Steuerungsvorrichtung kostengünstig in ein Gesamtsteuerungssystem integriert werden.

Vorzugsweise weist die Empfängereinheit eine elektromagnetische Abschirmung zum Schutz vor elektromagnetischer Störstrahlung auf. Die Störstrahlung kann die Signalerfassung in der Empfängereinheit stören und dadurch Fehlauslösungen verursachen.

In einer bevorzugten Ausführung der Erfindung ist die Erfassungsvorrichtung an einem Tor montiert, vorzugsweise an einer Schließkante des Tors. Dadurch kann die Erfassungsvorrichtung als eine dem Tor vorauseilende Lichtschranke ausgebildet sein. Hierbei kann die Sendereinheit an einer ersten Seite des Tors angeordnet sein und die Empfängereinheit an einer der ersten Seite gegenüberliegenden zweiten Seite angeordnet sein. Alternativ können die Sendereinheit und die Empfängereinheit auf der gleichen Seite des Tors angeordnet sein, wobei auf der gegenüberliegenden Seite ein Reflektor vorgesehen ist. Grundsätzlich ist unter einem Tor jede beliebige Art eines Tors zu verstehen, insbesondere ein Sektionaltor, Folientor, Schiebetor oder Rolltor.

Erfindungsgemäß sind in einem Verfahren zum Überwachen einer Maschinenbewegung die folgenden Schritte vorgesehen:
- Senden eines optischen Signals von einer Sendereinheit, wobei das optische Signal eine Sequenz von Signalpulsen mit verschiedenen Pulsintensitäten aufweist,
- Empfangen des optischen Signals an einer Empfängereinheit,
- Bestimmen der einzelnen Signalpulsintensitäten des empfangenen Signals,
- Auswerten der Pulsintensität eines über den Pulsauswahlindex vorbestimmten Signalpulses des empfangenen Signals in der Auswerteeinheit, wobei
   o bei Detektion einer Pulsintensität außerhalb eines erlaubten Intensitätsbereichs ein Auslöseimpulses zum Stoppen der Maschinenbewegung an eine Steuerungsvorrichtung ausgegeben wird, und
   o bei Detektion einer Pulsintensität innerhalb eines erlaubten Intensitätsbereichs ein Auswerten der Pulsintensität in einer Pulsauswahleinheit erfolgt, wobei bei Detektion einer Pulsintensität außerhalb eines optimalen Intensitätsbereichs ein Ändern des Pulsauswahlindex erfolgt.

Dadurch kann auch bei einer veränderlichen Signalintensität eine besonders zuverlässige und effiziente Überwachung der Maschinenbewegung erfolgen.

Vorzugsweise wird bei dem Auswerten der Pulsintensität des über den Pulsauswahlindex vorbestimmten Signalpulses in der Auswerteeinheit die Dauer der unerlaubten Pulsintensität erfasst, und bei Überschreiten einer vorgegebenen Mindestdauer die Ausgabe des Auslöseimpulses zum Stoppen der Maschinenbewegung an die Steuerungsvorrichtung erfolgt. Die Mindestdauer kann berechnet werden oder vorgegeben sein.

Vorteilhafterweise wird ein minimaler Intensitätswert oder ein maximaler Intensitätswert, welcher den erlaubten Intensitätsbereichs begrenzt, als Anteil eines Mittelwerts berechnet. Dies erlaubt beispielsweise eine dynamische Adaption des erlaubten Intensitätsbereichs an eine veränderte Signalintensität. Ferner kann der erlaubte Intensitätsbereich durch Variation des Anteils auf einfache Weise beispielweise an verschiedene Bewegungsgeschwindigkeiten der Maschine angepasst werden.

Vorzugsweise werden eine Mehrzahl optischer Signale gesendet und empfangen, wobei in der Auswerteeinheit für jedes optische Signal separat die Pulsintensität eines über einen Pulsauswahlindex vorbestimmten Signalpulses ausgewertet wird. Für jedes empfangene optische Signal ist somit ein separater Pulsauswahlindex vorgesehen. Dies ermöglicht für jedes empfangene optische Signal eine separate Auswahl eines Signalpulses mit einer geeigneten Pulsintensität.

Vorteilhafterweise wird bei Detektion einer Pulsintensität oberhalb des optimalen Intensitätsbereichs der Pulsauswahlindex verringert und bei Detektion einer Pulsintensität unterhalb des optimalen Intensitätsbereichs der Pulsauswahlindex erhöht. Dies ermöglicht eine einfache Anpassung des Pulsauswahlindex.

Ein Ausführungsbeispiel einer erfindungsgemäßen optoelektronischen Sicherheitsvorrichtung zum Überwachen einer Maschinenbewegung wird nachfolgend anhand der beigefügten Figuren beschrieben, wobei
Figur 1 eine schematische Frontalansicht eines Rolltors mit einer erfindurigsgemäßen optoelektronischen Sicherheitsvorrichtung zeigt,
Figur 2 eine schematische Draufsicht einer Erfassungsvorrichtung der Sicherheitsvorrichtung zeigt,
Figur 3 schematische Signalverläufe von optischen Signalen der Erfassungsvorrichtung zeigt,
Figur 4 eine schematische Verschaltung einer Steuerungsvorrichtung der Sicherheitsvorrichtung zeigt, und
Figur 5 einen erlaubten und einen optimalen Intensitätsbereich für ein empfangenes optisches Signal zeigt.

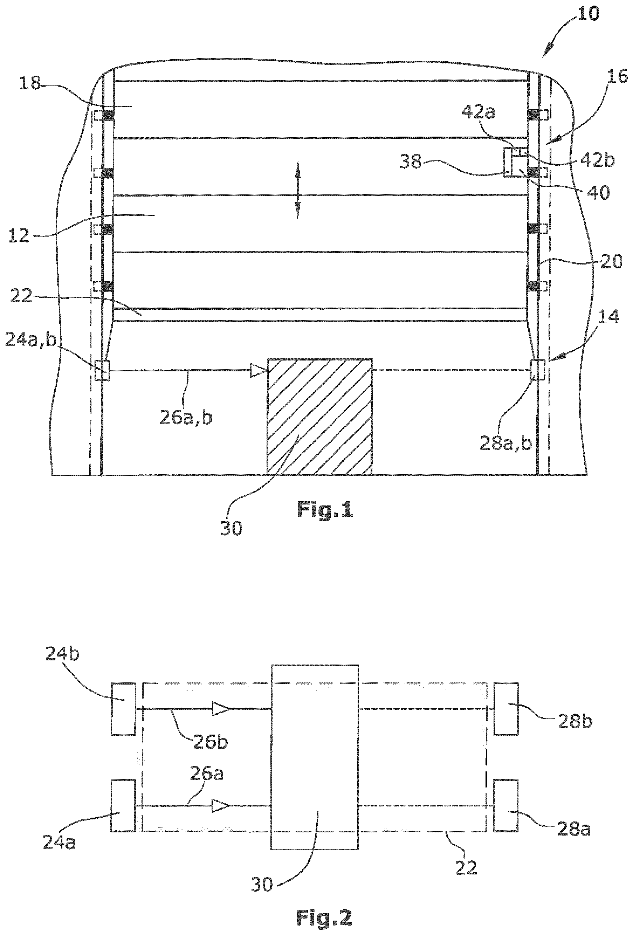

Figur 1 zeigt eine typische Anwendung einer erfindungsgemäßen Sicherheitsvorrichtung 10, wobei die Sicherheitsvorrichtung 10 die Bewegung eines automatisch betriebenen Rolltors 12 überwacht, das motorisch angetrieben auf und ab bewegbar ist. Die Sicherheitsvorrichtung 10 umfasst eine Erfassungsvorrichtung 14 und eine Steuerungsvorrichtung 16. Das Rolltor 12 besteht aus mehreren Torsegmenten 18, die seitlich in einer Führungsschiene 20 bewegbar gelagert sind. An einer Unterseite des Rolltors 12 ist eine Schließkante 22 angeordnet, die im verschlossenen Zustand an einem Boden zum Anliegen kommt.

Die Erfassungsvorrichtung 14 ist unterhalb der Schließkante 22 des Rolltors 12 angeordnet und umfasst zwei Sendereinheiten 24a,b zum Senden von optischen Signalen 26a,b und zwei Empfängereinheiten 28a,b zum Empfangen der optischen Signale 26a,b. Zur Ausbildung eines definierten Abstands zwischen der Erfassungsvorrichtung 14 und der Schließkante 22 sind die Sendereinheiten 24a,b und die Empfängereinheiten 28a,b an einem der Schließkante 22 nach unten hin hervorstehendem Steg oder einem Blech befestigt. Dadurch bildet die Erfassungsvorrichtung 14 ein dem Rolltor 12 beim Schließen bzw. Herabbewegen voreilendes Erfassungssystem, wobei der Abstand zwischen der Erfassungsvorrichtung 14 und der Schließkante 22 entsprechend einer erforderlichen Verzögerungszeit für ein kollisionsfreies Stoppen des Rolltors 12 nach Erfassen eines Hindernisses 30 ausgelegt ist. Die Sendereinheiten 24a,b und die Empfängereinheiten 28a,b sind jeweils an einem äußersten seitlichen Ende des Rolltors 12 befestigt und von der Führungsschiene 20 des Rolltors 12 zumindest teilweise umgeben, so dass die gesamte Breite des Rolltors 12 von der Erfassungsvorrichtung 14 überwacht werden kann. Die Sendereinheiten 24a,b und die Empfängereinheiten 28a,b sind - wie in Figur 2 gezeigt - in der Tiefenrichtung der Schließkante 22 angeordnet, wobei die Sendereinheit 24a und die Empfängereinheit 28a sich gegenüberstehend an der Vorderseite der Schließkante 22 angeordnet sind, und die Sendereinheit 24b und die Empfängereinheit 28b sich gegenüberstehend an der Rückseite der Schließkante 22 angeordnet sind. Um bei einem vollständigen Schließen des Tors 12 ein Anschlagen der Erfassungsvorrichtung 14 am Boden zu vermeiden, ist in dem Boden, im Bereich der Torführung 20, eine in Figur 1 nicht dargestellte Ausnehmung zum Versenken bzw. zur Aufnahme der Erfassungsvorrichtung 14 vorgesehen.

Vorliegend ist die Erfassungseinrichtung 14 durch zwei Lichtschranken ausgebildet, wobei ein erstes optisches Signal 26a von der Sendereinheit 24a ausgegeben und von der Empfängereinheit 28a empfangenen wird und ein zweites optisches Signal 26b von der Sendereinheit 24b ausgegeben und von der Empfängereinheit 28b empfangenen wird. Im Idealfall - wie in Figur 1 gezeigt - sind die Sendereinheiten 24a,b und die Empfängereinheiten 28a,b derart zueinander ausgerichtet, dass die optischen Signale 26a,b jeweils in der kürzesten Verbindungsstrecke zwischen der entsprechenden Sendereinheit 24a,b und der entsprechenden Empfängereinheit 28a,b verlaufen. Befindet sich - wie in Figur 1 gezeigt - ein Hindernis 30 im Bewegungsraum des Rolltors 12, wird das optische Signal 26a und/oder das optische Signal 26b der Erfassungsvorrichtung 14 unterbrochen, wodurch die von der entsprechenden Empfängereinheit 28a,b empfange Signalintensität des optischen Signals 26a,b zumindest deutlich reduziert wird bzw. im Idealfall vollständig ausgelöscht wird.

Die bei ungehinderter Übertragung der optischen Signale 26a,b von den Empfängereinheiten 28a,b empfangene Signalintensität ist unter anderem abhängig von dem Abstand zwischen der Sendereinheit 24a,b und der entsprechenden Empfängereinheit 28a,b und somit von der Breite des Rolltors 12. Das von der Sendereinheit 24a,b gesendete optische Signal 26a,b muss daher eine der Breite des Rolltors 12 angepasste Signalintensität aufweisen. Ferner können auch auf Grund von Umgebungseinflüssen, beispielsweise auf Grund von Temperaturänderungen oder witterungsbedingten Vibrationen des Rolltors 12, Änderungen der von der Empfängereinheit 28a,b empfangenen Signalintensität auftreten.

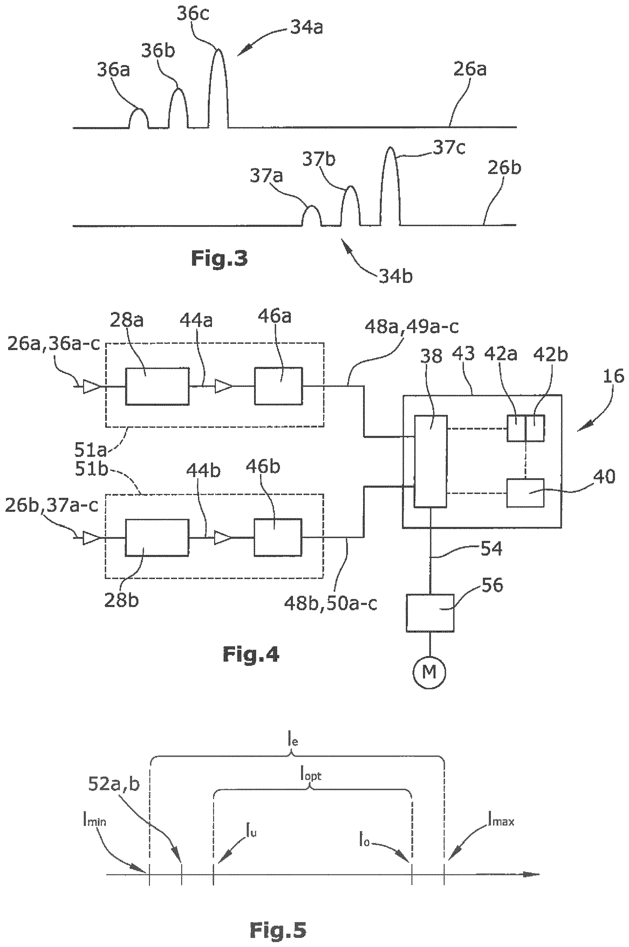

Um diese Änderungen der empfangenen Signalintensität bei ungehinderter Signalübertragung kompensieren zu können, weisen die optischen Signale 26a,b jeweils eine Sequenz 34a,b von drei Signalpulsen 36a-c bzw. 37a-c auf, wobei die Signalpulse innerhalb der Sequenz 34a,b jeweils eine von dem ersten Signalpuls 36a,37a zu dem letzten Signalpuls 36c,37c kontinuierlich ansteigende Pulsintensität aufweisen. Die Signalverläufe 32a,b der optischen Signale 26a,b sind in Figur 3 dargestellt, wobei der Signalverlauf 32a dem zeitlichen Verlauf der gesendeten Signalintensität des optischen Signals 26a entspricht und der Signalverlauf 32b dem zeitlichen Verlauf der gesendeten Signalintensität des optischen Signals 26b entspricht. Die Sequenzen 34a,b der beiden optischen Signale 26a,b werden hierbei zeitlich versetzt gesendet, um Interferenzen zu vermeiden.

Die Steuerungsvorrichtung 16 ist im vorliegenden Ausführungsbeispiel an dem Rolltor 12 angebracht, kann jedoch in einer alternativen Ausführung auch ortsfest angeordnet sein. Ferner kann die Steuerungsvorrichtung 16 auch in die Empfangsvorrichtung 14 integriert sein. Die Steuerungsvorrichtung umfasst eine Auswerteeinheit 38, eine Pulsauswahleinheit 40 und zwei Pulsauswahlindizes 42a,b. Die Verschaltung der Steuerungsvorrichtung 16 ist in Figur 4 schematisch dargestellt. Die Auswerteeinheit 38 dient der Auswertung der von den Empfängereinheiten 28a,b empfangenen Intensitäten der optischen Signale 26a,b, wobei die Auswerteeinheit 38 von jedem empfangenen optischen Signal 26a,b jeweils einen über die Pulsauswahlindizes 42a,b vorbestimmten Signalpuls 36a-c,37a-c auswertet. Die Pulsauswahleinheit 40 dient dazu, die Pulsauswahlindizes 42a,b entsprechend der empfangenen Pulsintensitäten der Signalpulse 36a-c,37a-c zu adaptieren. Die Auswerteeinheit 38, die Pulsauswahleinheit 40 und die Pulsauswahlindizes 42a,b sind in einen Mikrokontroller 43 integriert.

An den Empfängereinheiten 28a,b wird jeweils kontinuierlich das von den Sendereinheiten 24a,b gesendete optische Signal 26a,b empfangen und an einem Ausgang ein elektrisches Analogsignal 44a,b bereitgestellt, das den zeitlichen Verlauf der Signalintensität des empfangenen optischen Signals 26a,b wiedergibt. Die Analogsignale 44a,b werden jeweils in einem Analog-Digitalwandler 46a,b in ein Digitalsignal 48a,b umgewandelt. Die Digitalsignale 48a,b umfassen für jeden empfangenen Signalpuls 36a-c,37a-c der optischen Signale 26a,b einen Intensitätswert 49a-c bzw. 50a-c und werden der Auswerteeinheit 38 bereitgestellt. Zum Schutz der Empfängereinheiten 28a,b und der Analog-Digitalwandler 46a,b vor elektromagnetischer Störstrahlung sind elektromagnetische Abschirmungen 51a,b vorgesehen.

Die Auswerteeinheit 38 bestimmt für beide Digitalsignale 48a,b jeweils einen Auswerteintensitätswert 52a,b, wobei über die Pulsauswahlindizes 42a,b vorbestimmt ist, welche der empfangenen Intensitätswerte 49a-c,50a-c ausgewertet werden. Wenn einer der Auswerteintensitätswerte 52a,b außerhalb eines erlaubten Intensitätsbereichs Ie liegt, welcher - wie in Figur 5 gezeigt - durch eine minimale Intensität Imin und eine maximale Intensität Imax begrenzt ist, dann stellt die Auswerteeinheit 38 an einem Ausgang ein Auslösesignal 54 an eine Motorelektronik 56 bereit, wodurch ein sofortiger Stopp eines Antriebsmotors M bewirkt wird. Die minimale Intensität Imin und die maximale Intensität Imax können beispielsweise als ein Anteil eines Mittelwerts von Signalintensitäten berechnet werden. Ferner kann in der Auswerteeinheit 38 ein nicht gezeigtes Zeitmodul vorgesehen werden, das geeignet ist, die Dauer zu ermitteln, in der der Auswerteintensitätswert 52a,b außerhalb des erlaubten Intensitätsbereich Ie liegt. Hierbei wird erst bei Überschreitung einer Mindestdauer das Auslösesignal 54 bereitgestellt.

Wenn die Auswerteintensitätswerte 52a,b innerhalb des erlaubten Intensitätsbereichs Ie liegen, werden die Auswerteintensitätswerte 52a,b an die Pulsauswahleinheit 40 bereitgestellt und dort ausgewertet. Wenn einer der Auswerteintensitätswerte 52a,b außerhalb eines optimalen Intensitätsbereich Iopt liegt, welcher durch einen unteren Intensitätsschwellwert Iu und einen oberen Intensitätsschwellwert Io begrenzt ist, wird der entsprechende Pulsauswahlindex 42a,b durch die Pulsauswahleinheit 40 geändert. Liegt der Auswerteintensitätswert 52a,b unterhalb von Iu, wird der entsprechende Pulsauswahlindex 42a,b erhöht, um einen Signalpuls 36a-c,37a-c mit einer höheren Pulsintensität zu selektieren. Liegt der Auswerteintensitätswert 52a,b oberhalb von Io, wird der entsprechende Pulsauswahlindex 42a,b verringert, um einen Signalpuls 36a-c,37a-c mit einer geringeren Pulsintensität zu selektieren. Der Auswerteeinheit 38 werden somit, sofern kein Hindernis 30 die optischen Signale 26a,b unterbricht, Auswerteintensitätswerte 52a,b im optimalen Intensitätsbereich Iopt bereitgestellt.

Die erfindungsgemäße Sicherheitsvorrichtung ist somit geeignet, sich automatisch an eine geänderte Intensität des empfangenen Signals anzupassen. Hierdurch können zum einen im Betrieb auftretende Änderung der Signalintensität kompensiert werden, und zum anderen erlaubt die erfindungsgemäße Sicherheitsvorrichtung eine ordnungsgemäße Überwachung von Rolltoren mit verschiedenen Breiten, ohne dass hierfür eine manuelle Anpassung der Sicherheitsvorrichtung erforderlich ist.

### Bezugszeichenliste

- 10: Sicherheitsvorrichtung
- 12: Rolltor
- 14: Erfassungsvorrichtung
- 16: Steuerungsvorrichtung
- 18: Torsegmente
- 20: Führungsschiene
- 22: Schließkante
- 24a,b: Sendereinheiten
- 26a,b: optischen Signale
- 28a,b: Empfängereinheiten
- 30: Hindernis
- 32a,b: Signalverläufe
- 34a,b: Signalsequenzen
- 36a-c: Signalpulse
- 37a-c: Signalpulse
- 38: Auswerteeinheit
- 40: Pulsauswahleinheit
- 42a,b: Pulsauswahlindizes
- 43: Mikrokontroller
- 44a,b: Analogsignale
- 46a,b: Analog-Digitalwandler
- 48a,b: Digitalsignale
- 49a-c: Intensitätswerte
- 50a-c: Intensitätswerte
- 51a,b: elektromagnetische Abschirmungen
- 52a,b: Auswerteintensitätswerte
- 54: Auslösesignal
- 56: Motorelektronik
- M: Motor

## Patentansprüche

1. Optoelektronische Sicherheitsvorrichtung (10) zum Überwachen einer Maschinenbewegung, mit
einer Erfassungsvorrichtung (14), mit
mindestens einer Sendereinheit (24a,b) zum Senden eines optischen Signals (26a,b), und
mindestens einer Empfängereinheit (28a,b) zum Empfangen des optischen Signals (26a,b), und
einer Steuerungsvorrichtung (16) mit
einer Auswerteeinheit (38) zum Auswerten des an der Empfängereinheit empfangenen Signals (26a,b),
wobei die Steuerungsvorrichtung (16) bei einer Intensität des empfangenen Signals (52a,b) innerhalb eines erlaubten Intensitätsbereichs (Ie) die Maschinenbewegung freigibt und bei einer Intensität des empfangenen Signals (52a,b) außerhalb eines erlaubten Intensitätsbereichs (Ie) einen Auslöseimpuls (54) zum Stoppen der Maschinenbewegung ausgibt,
**dadurch gekennzeichnet, dass**
das optische Signal (26a,b) eine Sequenz (34a,b) von mehreren Signalpulsen (36a-c,37a-c) aufweist, wobei die Signalpulse (36a-c,37a-c) voneinander verschiedene Pulsintensitäten (49a-c,50a-c) aufweisen,
die Steuerungsvorrichtung (16) einen Pulsauswahlindex (42a,b) aufweist, über den ein in der Auswerteeinheit (38) auszuwertender Signalpuls (36a-c,37a-c) des empfangenen optischen Signals (26a,b) vorbestimmt ist, und
die Steuerungsvorrichtung (16) eine Pulsauswahleinheit (40) aufweist, die geeignet ist, bei einer Pulsintensität (52a,b) des über den Pulsauswahlindex (42a,b) vorbestimmten Signalpulses (36a-c,37a-c) außerhalb eines optimalen Intensitätsbereichs (Iopt) den Pulsauswahlindex (42a,b) zu ändern.

2. Optoelektronische Sicherheitsvorrichtung (10) nach Anspruch 1,
**dadurch gekennzeichnet, dass**
die Signalpulse (36a-c,37a-c) innerhalb der Sequenz (34a,b) eine von dem ersten Signalpuls (36a,37a) zu dem letzten Signalpuls (36c,37c) kontinuierlich ansteigende oder kontinuierlich abfallende Pulsintensität (49a-c,50a-c) aufweisen.

3. Optoelektronische Sicherheitsvorrichtung (10) nach einem der vorigen Ansprüche,
**dadurch gekennzeichnet, dass**
die Steuerungsvorrichtung (16), die Auswerteeinheit (38) oder die Pulsauswahleinheit (40) in die Erfassungsvorrichtung (14) integriert ist.

4. Optoelektronische Sicherheitsvorrichtung (10) nach einem der vorigen Ansprüche,
**dadurch gekennzeichnet, dass**
die Erfassungsvorrichtung (14) mindestens zwei Sendereinheiten (24a,b) und mindestens zwei Empfängereinheiten (28a,b) aufweist.

5. Optoelektronische Sicherheitsvorrichtung (10) nach Anspruch 4,
**dadurch gekennzeichnet, dass**
die Sendereinheiten (24a,b) ausgebildet sind, jeweils ein optisches Signal (26a,b) mit einer Sequenz (34a,b) von Signalpulsen (36a-c,37a-c) zu senden, wobei sich die Signalpulssequenzen (34a,b) der einzelnen Signale (26a,b) zeitlich nicht überlappen.

6. Optoelektronische Sicherheitsvorrichtung (10) nach Anspruch 3 oder 4,
**dadurch gekennzeichnet, dass**
die Steuerungsvorrichtung (16) mindestens zwei Pulsauswahlindizes (42a,b) aufweist.

7. Optoelektronische Sicherheitsvorrichtung (10) nach einem der vorigen Ansprüche,
**dadurch gekennzeichnet, dass**
die Steuerungsvorrichtung (16) oder die Auswerteeinheit (38) ein Zeitmodul aufweist, das geeignet ist, die Dauer der unerlaubten Signalintensität zu erfassen und bei Überschreiten einer Mindestdauer den Auslöseimpuls (54) zum Stoppen der Maschinenbewegung auszugeben.

8. Optoelektronische Sicherheitsvorrichtung (10) nach einem der vorigen Ansprüche,
**dadurch gekennzeichnet, dass**
die Empfängereinheit (28a,b) oder die Auswerteeinheit (38) geeignet ist, ein eingehendes Analogsignal (44a,b) in ein ausgehendes Digitalsignal (48a,b) umzuwandeln.

9. Optoelektronische Sicherheitsvorrichtung (10) nach einem der vorigen Ansprüche,
**dadurch gekennzeichnet, dass**
die Auswerteeinheit (38) oder die Pulsauswahleinheit (40) in einem Mikroprozessor (43) integriert ist.

10. Optoelektronische Sicherheitsvorrichtung (10) nach einem der vorigen Ansprüche,
**dadurch gekennzeichnet, dass**
die Empfängereinheit (28a,b) eine elektromagnetische Abschirmung aufweist (51a,b).

11. Optoelektronische Sicherheitsvorrichtung (10) nach einem der vorigen Ansprüche,
**dadurch gekennzeichnet, dass**
die Erfassungsvorrichtung (14) oder die Steuerungsvorrichtung (16) an einem Tor (12) montiert ist.

12. Verfahren zum Überwachen einer Maschinenbewegung mit den folgenden Schritten:
- Senden eines optischen Signals (26a,b) von einer Sendereinheit (24a,b), wobei das optische Signal (26a,b) eine Sequenz (34a,b) von Signalpulsen (36a-c,37a-c) mit verschiedenen Pulsintensitäten (49a-c,50a-c) aufweist,
- Empfangen des optischen Signals (26a,b) an einer Empfängereinheit (28a,b),
- Bestimmen der einzelnen Signalpulsintensitäten (49a-c,50a-c) des empfangenen Signals (26a,b),
- Auswerten der Pulsintensität (52a,b) eines über den Pulsauswahlindex (42a,b) vorbestimmten Signalpulses (36a-c,37a-c) des empfangenen Signals (26a,b) in der Auswerteeinheit (38), wobei
o bei Detektion einer Pulsintensität (52a,b) außerhalb eines erlaubten Intensitätsbereichs (Ie) ein Auslöseimpulses (54) zum Stoppen der Maschinenbewegung an eine Steuervorrichtung (56) ausgegeben wird, und
o bei Detektion einer Pulsintensität (52a,b) innerhalb eines erlaubten Intensitätsbereichs (Ie) ein Auswerten der Pulsintensität (52a,b) in einer Pulsauswahleinheit (40) erfolgt, wobei bei Detektion einer Pulsintensität (52a,b) außerhalb eines optimalen Intensitätsbereichs (Iopt) ein Ändern des Pulsauswahlindex (42a,b) erfolgt.

13. Verfahren nach Anspruch 12,
**dadurch gekennzeichnet, dass**
bei dem Auswerten der Pulsintensität (52a,b) des über den Pulsauswahlindex (42a,b) vorbestimmten Signalpulses (36a-c,37a-c) in der Auswerteeinheit (38) die Dauer der unerlaubten Pulsintensität (52a,b) erfasst wird, und bei Überschreiten einer vorgegebenen Mindestdauer die Ausgabe des Auslöseimpulses (54) zum Stoppen der Maschinenbewegung an die Steuervorrichtung (56) erfolgt.

14. Verfahren nach Anspruch 12 oder 13,
**dadurch gekennzeichnet, dass**
ein minimaler Intensitätswert (Imin) oder ein maximaler Intensitätswert (Imax), welcher den erlaubten Intensitätsbereichs (Ie) begrenzt, als Anteil eines Mittelwerts berechnet wird.

15. Verfahren nach Anspruch 12 bis 14,
**dadurch gekennzeichnet, dass**
eine Mehrzahl optischer Signale (26a,b) gesendet und empfangen werden, wobei in der Auswerteeinheit (38) für jedes optische Signal (26a,b) separat die Pulsintensität (52a,b) eines über einen Pulsauswahlindex (42a,b) vorbestimmten Signalpulses (36a-c,37a-c) ausgewertet wird.

16. Verfahren nach Anspruch 12 bis 15,
**dadurch gekennzeichnet, dass**
bei Detektion einer Pulsintensität (52a,b) oberhalb des optimalen Intensitätsbereichs (Iopt) der Pulsauswahlindex (42a,b) verringert wird und
bei Detektion einer Pulsintensität (52a,b) unterhalb des optimalen Intensitätsbereichs (Iopt) der Pulsauswahlindex (42a,b) erhöht wird.

## Claims

1. Optoelectronic safety device (10) for monitoring a machine movement, comprising
a detection device (14), with
at least one transmitter unit (24a,b) for transmitting an optical signal (26a,b), and
at least one receiver unit (28a,b) for receiving the optical signal (26a,b), and
a control device (16) with
an evaluation unit (38) for evaluating the signal (26a,b) received at the receiver unit,
the control device (16) releasing the machine movement when the intensity of the received signal (52a,b) is within an allowed intensity range (Ie) and outputting a triggering pulse (54) to stop the machine movement when the intensity of the received signal (52a,b) is outside an allowed intensity range (Ie),
**characterised in that**
the optical signal (26a,b) comprises a sequence (34a,b) of a plurality of signal pulses (36a-c,37a-c), the signal pulses (36a-c,37a-c) having different pulse intensities (49a-c,50a-c) from one another,
the control device (16) comprises a pulse selection index (42a,b) by means of which a signal pulse (36a-c,37a-c) of the received optical signal (26a,b) to be evaluated in the evaluation unit (38) is predetermined, and
the control device (16) comprises a pulse selection unit (40) which is suitable for changing the pulse selection index (42a,b) if the pulse intensity (52a,b) of the signal pulse (36a c,37a c) predetermined via the pulse selection index (42a,b) is outside an optimal intensity range (Iopt).

2. Optoelectronic safety device (10) according to claim 1,
**characterized in that**
the signal pulses (36a-c,37a-c) within the sequence (34a,b) comprise a pulse intensity (49a-c,50a c) continuously increasing or continuously decreasing from the first signal pulse (36a,37a) to the last signal pulse (36c,37c).

3. Optoelectronic safety device (10) according to one of the preceding claims,
**characterized in that**
the control device (16), the evaluation unit (38) or the pulse selection unit (40) is integrated in the detection device (14).

4. Optoelectronic safety device (10) according to any one of the preceding claims,
**characterized in that**
the detection device (14) comprises at least two transmitter units (24a,b) and at least two receiver units (28a,b).

5. Optoelectronic safety device (10) according to claim 4,
**characterized in that**
the transmitter units (24a,b) are configured to respectively transmit an optical signal (26a,b) with a sequence (34a,b) of signal pulses (36a-c,37a-c), wherein the signal pulse sequences (34a,b) of the individual signals (26a,b) do not overlap in time.

6. Optoelectronic safety device (10) according to claim 3 or 4, **characterized in that**
the control device (16) comprises at least two pulse selection indices (42a,b).

7. Optoelectronic safety device (10) according to any one of the preceding claims,
**characterized in that**
the control device (16) or the evaluation unit (38) comprises a time module which is suitable for detecting the duration of the invalid signal intensity and, if a minimum duration is exceeded, for outputting the triggering pulse (54) for stopping the machine movement.

8. Optoelectronic safety device (10) according to any one of the preceding claims,
**characterised in that**
the receiver unit (28a,b) or the evaluation unit (38) is adapted to convert an incoming analogue signal (44a,b) into an outgoing digital signal (48a,b).

9. Optoelectronic safety device (10) according to any one of the preceding claims,
**characterized in that**
the evaluation unit (38) or the pulse selection unit (40) is integrated in a microprocessor (43).

10. Optoelectronic safety device (10) according to any one of the preceding claims,
**characterized in that**
the receiver unit (28a,b) comprises an electromagnetic shield (51a,b).

11. Optoelectronic safety device (10) according to any one of the preceding claims,
**characterized in that**
the detection device (14) or the control device (16) is mounted at a gate (12).

12. Method for monitoring a machine movement comprising the following steps:
- Transmitting an optical signal (26a,b) from a transmitter unit (24a,b), the optical signal (26a,b) comprising a sequence (34a,b) of signal pulses (36a-c,37a-c) having different pulse intensities (49a-c,50a c),
- receiving the optical signal (26a,b) at a receiver unit (28a,b),
- determining the individual signal pulse intensities (49a-c,50a c) of the received signal (26a,b),
- evaluating the pulse intensity (52a,b) of a signal pulse (36a c,37a c) of the received signal (26a,b) predetermined via the pulse selection index (42a,b) in the evaluation unit (38), wherein
when a pulse intensity (52a,b) outside of an allowed intensity range (Ie) is detected, a triggering pulse (54) for stopping the machine movement is output to a control device (56), and
when a pulse intensity (52a,b) within an allowed intensity range (Ie) is detected, an evaluation of the pulse intensity (52a,b) in a pulse selection unit (40) is made, wherein when a pulse intensity (52a,b) outside an optimal intensity range (Iopt) is detected, a change of the pulse selection index (42a,b) is made.

13. Method according to claim 12,
**characterised in that**
when the pulse intensity (52a,b) of the signal pulse (36a-c,37a-c) predetermined via the pulse selection index (42a,b) is evaluated in the evaluation unit (38), the duration of the unauthorised pulse intensity (52a,b) is detected, and if a predetermined minimum duration is exceeded, the triggering pulse (54) for stopping the machine movement is output to the control device (56).

14. Method according to claim 12 or 13,
**characterised in that**
a minimum intensity value (Imin) or a maximum intensity value (Imax), which limits the allowed intensity range (Ie), is calculated as a fraction of a mean value.

15. Method according to claim 12 to 14,
**characterised in that**
a plurality of optical signals (26a,b) are transmitted and received, the pulse intensity (52a,b) of a signal pulse (36a c,37a-c) predetermined via a pulse selection index (42a,b) being evaluated separately in the evaluation unit (38) for each optical signal (26a,b).

16. Method according to claim 12 to 15,
**characterised in that**
when a pulse intensity (52a,b) above the optimum intensity range (Iopt) is detected, the pulse selection index (42a,b) is reduced, and
when a pulse intensity (52a,b) below the optimum intensity range (Iopt) is detected, the pulse selection index (42a,b) is increased.

## Revendications

1. Appareil de sécurité opto-électronique (10) pour la surveillance d'un mouvement de machine, qui comprend
un appareil de détection (14), avec
au moins une unité d'émission (24a, b) pour émettre un signal optique (26a, b), et
au moins une unité de réception (28a, b) pour recevoir le signal optique (26a, b), et
un appareil de contrôle (16) avec
une unité d'évaluation (38) pour évaluer le signal (26a, b) reçu sur l'unité de réception,
l'appareil de contrôle (16) libérant le mouvement de la machine lorsque l'intensité du signal reçu (52a, b) se situe dans une zone d'intensité autorisée (Ie) et émettant une impulsion de déclenchement (54) pour arrêter le mouvement de la machine lorsque l'intensité du signal reçu (52a, b) se situe en dehors d'une zone d'intensité autorisée (Ie),
**caractérisé en ce que**
le signal optique (26a, b) comprend une séquence (34a, b) d'une pluralité d'impulsions de signal (36a-c, 37a-c), les impulsions de signal (36a-c, 37a-c) ayant des intensités d'impulsion (49a-c, 50a-c) différentes les unes des autres,
l'appareil de contrôle (16) comprend un indice de sélection d'impulsion (42a,b) au moyen duquel une impulsion de signal (36a-c, 37a-c) du signal optique reçu (26a,b) à évaluer dans l'unité d'évaluation (38) est prédéterminée, et
l'appareil de contrôle (16) comprend une unité de sélection d'impulsion (40) qui est appropriée pour changer l'indice de sélection d'impulsion (42a, b) si l'intensité d'impulsion (52a, b) de l'impulsion de signal (36a c, 37a c) prédéterminée via l'indice de sélection d'impulsion (42a, b) se trouve en dehors d'une zone d'intensité optimale (Iopt).

2. Appareil de sécurité optoélectronique (10) selon la revendication 1, **caractérisé en ce que**
les impulsions de signal (36a-c, 37a-c) à l'intérieur de la séquence (34a,b) comprennent une intensité d'impulsion (49a-c, 50a-c) augmentant de manière continue ou diminuant de manière continue de la première impulsion de signal (36a,37a) à la dernière impulsion de signal (36c,37c).

3. Appareil de sécurité optoélectronique (10) selon l'une des revendications précédentes,
**caractérisé en ce que**
l'appareil de contrôle (16), l'unité d'évaluation (38) ou l'unité de sélection d'impulsion (40) est intégré dans l'appareil de détection (14).

4. Appareil de sécurité optoélectronique (10) selon l'une quelconque des revendications précédentes,
**caractérisé en ce que**
l'appareil de détection (14) comprend au moins deux unités d'émission (24a,b) et au moins deux unités de réception (28a,b).

5. Appareil de sécurité optoélectronique (10) selon la revendication 4, **caractérisé en ce que**
les unités émettrices (24a, b) sont configurées pour transmettre respectivement un signal optique (26a, b) avec une séquence (34a, b) d'impulsions de signal (36a-c, 37a-c), les séquences d'impulsions de signal (34a, b) des signaux individuels (26a, b) ne se chevauchant pas en temps.

6. Appareil de sécurité optoélectronique (10) selon la revendication 3 ou 4, **caractérisé en ce que**
l'appareil de contrôle (16) comprend au moins deux indices de sélection d'impulsions (42a,b).

7. Appareil de sécurité optoélectronique (10) selon l'une quelconque des revendications précédentes,
**caractérisé en ce que**
l'appareil de contrôle (16) ou l'unité d'évaluation (38) comprend un module temporel qui est approprié pour détecter la durée de l'intensité du signal invalide et, si une durée minimale est dépassée, pour émettre l'impulsion de déclenchement (54) pour arrêter le mouvement de la machine.

8. Appareil de sécurité optoélectronique (10) selon l'une quelconque des revendications précédentes,
**caractérisé en ce que**
l'unité de réception (28a,b) ou l'unité d'évaluation (38) est adaptée pour convertir un signal analogique entrant (44a,b) en un signal digital sortant (48a,b).

9. Appareil de sécurité optoélectronique (10) selon l'une quelconque des revendications précédentes,
**caractérisé en ce que**
l'unité d'évaluation (38) ou l'unité de sélection des impulsions (40) est intégrée dans un microprocesseur (43).

10. Appareil de sécurité optoélectronique (10) selon l'une quelconque des revendications précédentes,
**caractérisé en ce que**
l'unité de réception (28a,b) comprend un écran électromagnétique (51a,b).

11. Appareil de sécurité optoélectronique (10) selon l'une quelconque des revendications précédentes,
**caractérisé en ce que**
l'appareil de détection (14) ou l'appareil de contrôle (16) est monté sur un portail (12).

12. Méthode de surveillance d'une marche d'une machine comprenant les étapes suivantes :
- émettre un signal optique (26a,b) à partir d'une unité d'émission (24a,b), le signal optique (26a,b) comprend une séquence (34a,b) d'impulsions de signal (36a-c, 37a-c) ayant des intensités d'impulsion différentes (49a-c, 50a c),
- recevoir le signal optique (26a,b) au niveau d'une unité de réception (28a,b),
- déterminer les intensités d'impulsion individuelles (49a-c, 50a c) du signal reçu (26a,b),
- évaluer l'intensité d'impulsion (52a, b) d'une impulsion de signal (36a c, 37a c) du signal reçu (26a, b) prédéterminée par l'intermédiaire de l'indice de sélection d'impulsion (42a, b) dans l'unité d'évaluation (38), dans lequel lorsqu'une intensité d'impulsion (52a, b) en dehors d'une zone d'intensité autorisée (Ie) est détectée, une impulsion de déclenchement (54) pour arrêter le mouvement de la machine est délivrée à un appareil de contrôle (56), et
lorsqu'une intensité d'impulsion (52a, b) à l'intérieur d'une zone d'intensité autorisée (Ie) est détectée, une évaluation de l'intensité d'impulsion (52a, b) dans une unité de sélection d'impulsion (40) est effectuée, dans laquelle lorsqu'une intensité d'impulsion (52a, b) à l'extérieur d'une zone d'intensité optimale (Iopt) est détectée, un changement de l'indice de sélection d'impulsion (42a, b) est effectué.

13. Méthode selon la revendication 12,
**caractérisé en ce que**
lorsque l'intensité d'impulsion (52a,b) de l'impulsion de signal (36a-c, 37a-c) prédéterminée via l'indice de sélection d'impulsion (42a,b) est évaluée dans l'unité d'évaluation (38), la durée de l'intensité d'impulsion non autorisée (52a,b) est détectée, et si une durée minimale prédéterminée est dépassée, l'impulsion de déclenchement (54) pour arrêter le mouvement de la machine est émise vers l'appareil de contrôle (56).

14. Méthode selon la revendication 12 ou 13,
**caractérisé en ce que**
une valeur d'intensité minimale (Imin) ou une valeur d'intensité maximale (Imax), qui limite la zone d'intensité autorisée (Ie), est calculée comme une fraction d'une valeur moyenne.

15. Méthode selon les revendications 12 à 14,
**caractérisé en ce que**
une pluralité de signaux optiques (26a, b) est émise et reçue, l'intensité d'impulsion (52a, b) d'une impulsion de signal (36a c, 37a-c) prédéterminée via un indice de sélection d'impulsion (42a, b) est évaluée séparément dans l'unité d'évaluation (38) pour chaque signal optique (26a, b).

16. Méthode selon les revendications 12 à 15,
**caractérisé en ce que**
lorsqu'une intensité d'impulsion (52a,b) supérieure à la zone d'intensité optimale (Iopt) est détectée, l'indice de sélection d'impulsion (42a,b) est réduit, et
lorsqu'une intensité d'impulsion (52a, b) inférieure à la zone d'intensité optimale (Iopt) est détectée, l'indice de sélection d'impulsion (42a, b) est augmenté.
